Europäisches Patentamt

European Patent Office

Office européen des brevets

(19)

(11) EP 0 692 098 B1

(12)

# FASCICULE DE BREVET EUROPEEN

(45) Date de publication et mention
de la délivrance du brevet:
**28.05.1997 Bulletin 1997/22**

(21) Numéro de dépôt: **94911993.7**

(22) Date de dépôt: **29.03.1994**

(51) Int Cl.⁶: **G01R 15/00, H01F 27/255**

(86) Numéro de dépôt international:
**PCT/FR94/00351**

**WO 94/23305 (13.10.1994 Gazette 1994/23)**

(54) **DISPOSITIF DE MESURE DE COURANT ELECTRIQUE COMPORTANT UN CAPTEUR SENSIBLE AU FLUX MAGNETIQUE ET DESTINE EN PARTICULIER AUX VEHICULES A PROPULSION ELECTRIQUE**

VORRICHTUNG ZUR MESSUNG VON ELEKTRISCHEM STROM MIT EINEM AUF MAGNETFLUSS ANSPRECHENDEN WANDLER, INSBESONDERE FÜR DIE VERWENDUNG BEI ELEKTRISCH BETRIEBENEN FAHRZEUGEN

ELECTRIC CURRENT MEASURING DEVICE WITH A MAGNETIC FLUX SENSOR, IN PARTICULAR FOR ELECTRIC VEHICLES

(84) Etats contractants désignés:
**AT BE CH DE DK ES FR GB GR IE IT LI LU MC NL PT SE**

(30) Priorité: **29.03.1993 FR 9303612**

(43) Date de publication de la demande:
**17.01.1996 Bulletin 1996/03**

(73) Titulaire: **MECAGIS**
**F-45200 Montargis (FR)**

(72) Inventeurs:
• **BERNA, Michel**
**F-03230 Lusigny (FR)**
• **COLOMBEL, Luc**
**F-91540 Mennecy (FR)**
• **RAHOLIJAONA, Rouelle**
**F-45700 Villemandeur (FR)**

(74) Mandataire: **Obolensky, Michel et al**
**c/o CABINET LAVOIX**
**2, place d'Estienne d'Orves**
**75441 Paris Cédex 09 (FR)**

(56) Documents cités:
**EP-A- 0 133 695        EP-A- 0 392 439**
**DE-A- 2 710 675        US-A- 5 103 163**
**US-A- 5 172 052**

• **PATENT ABSTRACTS OF JAPAN vol. 8, no. 277 (E-285) 18 Décembre 1984 & JP,A,59 147 415 (HITACHI KINZOKU) 23 Août 1984**
• **PATENT ABSTRACTS OF JAPAN vol. 9, no. 318 (E-366) (2041) 13 Décembre 1985 & JP,A,60 152 012 (SHARP) 10 Août 1985**
• **PATENT ABSTRACTS OF JAPAN vol. 8, no. 277 (E-285) 18 Décembre 1984 & JP-A-59 147 415**
• **PATENT ABSTRACTS OF JAPAN vol. 9, no. 318 (E-366) (2041) 13 Décembre 1985 & JP-A-60 152 012**

## Description

La présente invention est relative à un dispositif de mesure de courant électrique comportant un capteur sensible au flux magnétique et destiné à mesurer l'intensité d'un courant électrique parcourant au moins un conducteur électrique.

On sait que les capteurs de courant à effet Hall à flux nul sont utilisés pour la mesure de l'intensité de courants électriques alternatifs ou continus, notamment dans les véhicules automobiles pour mesurer l'intensité du courant électrique de charge et de décharge des batteries.

De tels capteurs sont généralement constitués d'un noyau magnétique feuilleté présentant au moins un entrefer et sur lequel est disposé au moins un bobinage de flux nul, d'une sonde à effet Hall logée dans l'entrefer, alimentée en courant continu issu de deux sources symétriques et délivrant un signal de sortie à l'entrée, d'un bloc électronique amplificateur, ledit amplificateur étant connecté en sortie à l'une des extrémités du bobinage de flux nul, et d'une résistance de mesure d'un courant dit de flux nul qui est reliée, d'une part, à l'extrémité opposée dudit bobinage de flux nul et d'autre part à la masse électrique.

Le courant électrique à mesurer est celui qui parcourt un conducteur électrique autour duquel est disposé le noyau magnétique du capteur de courant.

D'une façon générale, mais en particulier dans les véhicules automobiles électriques, ces dispositifs de mesure sont alimentés par des batteries ayant une tension nominale de 16V délivrant le plus souvent des tensions comprises entre 9 et 16V. De ce fait les dispositifs de mesure outre le noyau magnétique, la sonde à effet Hall, la boucle de régulation et la résistance de mesure, comportent un circuit convertisseur continu-continu, destiné à délivrer des tensions de +12V et -12V. Ce convertisseur dont l'excursion entre les deux tensions doit être supérieure à 18V, car imposée par la taille du circuit magnétique, et par conséquent de la résistance de l'enroulement de compensation, ou bobinage de flux nul, complique le dispositif de mesure, augmente son encombrement et son prix de revient.

EP-A-0 392 439 décrit un dispositif de mesure de courant par sonde à effet Hall comportant une sonde à effet Hall disposée dans l'entrefer d'un circuit magnétique et un enroulement bobiné sur le noyau du circuit magnétique. La mesure d'un courant porté par un conducteur traversant le circuit magnétique est faite en additionnant la tension générée par la sonde à effet Hall et la tension induite dans l'enroulement. Cette disposition qui n'est pas "à flux nul" est particulièrement adaptée à la mesure de la composante impulsionnelle de courants ayant une composante continue. Mais elle est peu adaptée à la mesure précise de la composante continue.

US-A-5 103 163 décrit un dispositif de mesure par sonde à effet Hall dans lequel le courant à mesurer constitue un bobinage traversé par un circuit magnétique ayant un entrefer dans lequel, avec la sonde à effet Hall, on mesure le champ magnétique induit.

Ce dispositif est peu précis.

Le but de la présente invention vise à remédier à ces inconvénients.

A cet effet, la présente invention a pour objet un dispositif de mesure de courant électrique comprenant au moins une sonde sensible au flux magnétique disposée dans l'entrefer d'un noyau annulaire destiné à être traversé par au moins un conducteur de courant à mesurer, un enroulement de compensation bobiné sur le noyau, une résistance de mesure connectée en série avec l'enroulement de compensation, caractérisé en ce que le noyau magnétique est un élément en matériau massif, en ce qu'il comporte en outre un circuit de régulation du courant d'alimentation de l'enroulement de compensation, quel que soit le sens du courant à mesurer, piloté par le signal de sortie du capteur sensible au flux magnétique et en ce que le nombre de spires de l'enroulement de compensation est rendu compatible avec le courant à mesurer, la tension maximale d'alimentation disponible et la plage de mesure de la résistance de mesure du dispositif.

Selon une première forme de réalisation de l'invention, le noyau magnétique a une forme de tore, le diamètre moyen de ce tore est compris entre 10 et 200 mm et de préférence compris entre 30 et 50 mm pour un calibre de 200 à 1000 A.

Avantageusement, l'élément massif est constitué par un fil.

Selon un autre mode de réalisation de l'invention, l'élément massif est un méplat. Avantageusement, ce méplat a une épaisseur comprise entre 0,5 et 2 mm et une largeur comprise entre 1 et 5 mm.

Selon encore un autre mode de réalisation de l'invention, l'élément massif est constitué par une bande dont les extrémités ménagent entre elles l'entrefer et sont relevées vers l'extérieur dudit élément massif de manière à faire face à la sonde à effet Hall. Avantageusement, cette bande a une épaisseur comprise entre 0,1 et 0,5 mm et une largeur comprise entre 2 et 5 mm.

Avantageusement, le matériau magnétique est un alliage de fer et de nickel, par exemple possédant la composition pondérale suivante :

Fer : 15%, Nickel : 75% à 82%, Molybdène : 3% à 7%, Cuivre : 0% à 5%.

De préférence, le matériau magnétique possède la composition suivante :

Fer : 15%, Nickel : 80%, Molybdène : 5%.

En outre, le matériau magnétique possède, après sa mise en forme et un éventuel traitement thermique un champ coercitif inférieur ou égal à 10 mOe.

D'autres caractéristiques et avantages ressortiront de la description qui suit d'exemples de réalisation de l'invention, faite en se référant aux dessins annexés sur lesquels :

- la figure 1 représente le schéma de principe d'un dispositif selon l'invention ;
- la figure 2 représente en section une autre forme de réalisation du noyau magnétique ;
- les figures 3 et 4 représentent en vue de face et de profil un autre mode de réalisation de l'invention; et
- la figure 5 illustre encore un autre mode de réalisation de l'invention.

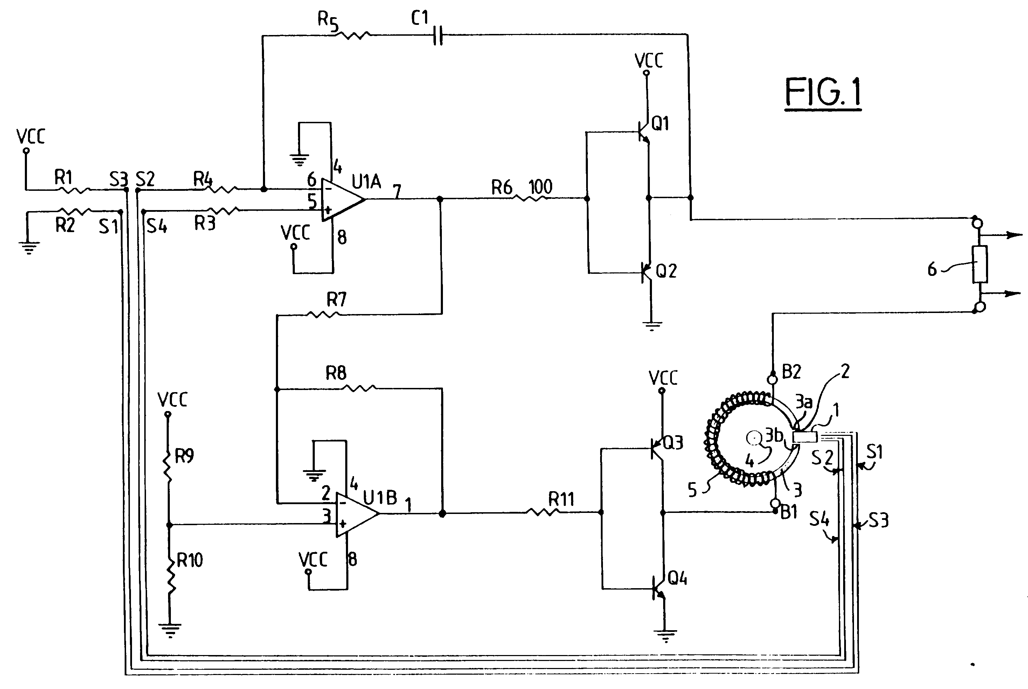

La figure 1 représente un dispositif de mesure de courant électrique comportant une sonde sensible au flux magnétique 1 telle qu'un capteur à effet Hall par exemple placée dans l'entrefer 2 d'un noyau annulaire 3 de forme générale torique par exemple.

La sonde peut également être constituée d'une magnétorésistance.

Le noyau 3 est traversé par un conducteur 4 parcouru par un courant à mesurer et porte un enroulement de compensation 5.

La sonde 1 comporte deux conducteurs d'alimentation S1, S3 au moyen desquels elle est connectée aux bornes d'une source d'alimentation en tension Vcc telle que par exemple celle disponible à bord d'un véhicule automobile électrique et qui bien que prévue pour délivrer une tension nominale de 16V, ne délivre généralement qu'une tension comprise entre 9 et 16V.

La sonde 1 est connectée à la source d'alimentation respectivement par l'intermédiaire de résistances de polarisation R1,R2.

La sonde 1 comporte en outre deux conducteurs de sortie qui sont connectés aux bornes S2,S4 d'un circuit de régulation comprenant un amplificateur alimenté par la tension Vcc dont la borne inverseuse est connectée à la borne S2 par l'intermédiaire d'une résistance R4 et dont la borne non inverseuse est connectée à l'entrée S4 par l'intermédiaire d'une résistance R3.

La sortie de l'amplificateur V1A est connectée par l'intermédiaire d'une résistance R6 aux bases d'une paire de transistors Q1,Q2 de types NPN et PNP respectivement dont les trajets émetteur-collecteur sont connectés en série entre la tension d'alimentation Vcc et la masse.

Entre la jonction des émetteurs des transistors Q1,Q2 et l'entrée inverseuse de l'amplificateur U1A est connecté un circuit RC série comprenant une résistance R5 et un condensateur C1.

Le point de jonction des émetteurs des transistors Q1,Q2 est en outre connecté à une première borne d'une résistance de mesure 6 dont l'autre borne est reliée à une première borne de l'enroulement de compensation 5.

La sortie de l'amplificateur U1A est en outre connectée par l'intermédiaire d'une résistance R7 à l'entrée inverseuse d'un second amplificateur U1B. Une résistance R8 relie cette entrée de l'amplificateur U1B à sa sortie.

L'entrée non inverseuse de cet amplificateur est connectée à un diviseur de tension formé de résistances R9,R10 connectées en série entre la tension d'alimentation Vcc et la masse.

L'amplificateur U1B est également alimenté par la tension Vcc.

La sortie de l'amplificateur U1B est connectée par une résistance R11 aux bases d'une seconde paire de transistors Q3,Q4 de types PNP et NPN respectivement dont les trajets collecteur-émetteur sont connectés en série entre la tension d'alimentation Vcc et la masse et dont la jonction entre les émetteurs est connectée à la seconde borne de l'enroulement de compensation 5.

Le circuit qui vient d'être décrit doit satisfaire à un certain nombre de conditions.

En supposant que le courant à mesurer parcourant le conducteur 4 a une intensité I1 et que le courant qui circule dans l'enroulement de compensation 5 et par conséquent dans la résistance de mesure a une intensité I2 et que l'enroulement de compensation 5 comporte n spires, pour un fonctionnement à flux nul on doit avoir

$$I2 = \frac{I1}{n}.$$

La résistance de mesure 6 ayant une valeur Rm et celle de l'enroulement de compensation 5 ayant une valeur Rc, la relation qui doit être respectée est :

$$I2 \, (Rm+Rc) < Vcc$$

Par ailleurs la tension aux bornes de la résistance de mesure Vm = I2Rm est imposée à 5V pour la pleine échelle du courant à mesurer. Il en résulte une relation indispensable à tenir sur toute la gamme d'alimentation disponible et sur toute la gamme de températures

$$Rc < \frac{Vcc - Vm}{I1 \times n}.$$

Or la résistance Rc de l'enroulement de compensation dépend de sa longueur et par conséquent du diamètre de la section du noyau 3 sur lequel est enroulé l'enroulement de compensation 5. L'utilisation d'un matériau magnétique massif permet de réduire considérablement la section du noyau 3 de sorte qu'à nombre de spires égal par rapport à un enroulement bobiné sur un noyau feuilleté classique on obtient un enroulement de compensation de résistance Rc réduite.

Le fonctionnement du circuit qui vient d'être décrit est le suivant.

On suppose tout d'abord qu'un courant I1 à mesurer parcourt le conducteur 4 dans un premier sens.

Ce courant I1 créé dans le noyau 3 qui entoure le conducteur 4 a un champ qui est détecté par la sonde 1. La tension de sortie de la sonde 1 est appliquée aux bornes S2,S4 et transmise aux entrées de l'amplificateur U1A. Le signal de sortie de l'amplificateur U1A est appliqué aux bases des transistors Q1,Q2 d'une part et par l'intermédiaire de l'amplificateur U1B qui l'inverse aux bases des transistors Q3 et Q4 d'autre part.

On suppose par exemple que le signe de la tension de sortie de la sonde 1 provoque l'apparition à la sortie de l'amplification U1A d'un signal assurant le déblocage du transistor Q1 et par conséquent maintenant bloqué le conducteur Q2.

Ce même signal de sortie de l'amplificateur U1A, après inversion dans l'amplificateur U1B assure le déblocage du transistor Q4.

Par conséquent la tension d'alimentation Vcc est appliquée par l'intermédiaire du transistor Q1 rendu conducteur à la résistance de mesure 6 et à l'enroulement de compensation 5, le courant qui en résulte s'écoulant vers la masse par le trajet émetteur-collecteur du transistor Q4 rendu également conducteur.

Lorsque le courant à mesurer parcourant le conducteur 4 est de sens contraire à celui précédemment indiqué, le signal de sortie du capteur 1 engendre à la sortie de l'amplificateur U1A un signal de sens contraire au précédent qui provoque la conduction du transistor Q2 et le blocage du transistor Q1.

D'une façon analogue ce même signal provoque après inversion dans l'amplificateur U1B la conduction du transistor Q3 et le blocage du transistor Q4. Par conséquent la tension Vcc est cette fois appliquée à l'enroulement de compensation 5 et à la résistance de mesure dans le sens contraire au sens précédent et le courant qui en résulte circule vers la masse par l'intermédiaire du transistor Q2 rendu conducteur.

On voit donc qu'il est ainsi possible d'assurer la régulation du courant circulant dans l'enroulement de compensation 5 et dans la résistance de mesure 6 quel que soit le sens du courant à mesurer circulant dans le conducteur 4 traversant le noyau 3 du dispositif.

Avantageusement, le noyau magnétique 3 est formé d'un élément massif en matériau magnétique qui est dans cet exemple de réalisation un fil de section circulaire.

Pour un fil de section circulaire, on utilise un diamètre compris entre 1,5 et 10 mm, de préférence compris entre 2 et 4 mm et par exemple égal à 2,4 mm.

La condition minimale requise pour les dimensions du fil, ou de manière générale de l'élément massif 3, au droit de l'entrefer 2 réside dans le fait que la surface de chaque extrémité 3a ou 3b de l'élément massif soit au moins égale à celle de la partie active de la sonde à effet Hall 1. Le fil 3 peut également posséder une section rectangulaire ou d'une autre forme appropriée.

Le tore a un diamètre moyen compris entre 10 et 200 mm, de préférence compris entre 30 et 50 mm pour un calibre de 200 à 1000 A et par exemple égal à 32 mm.

L'entrefer 2 du tore a une largeur comprise entre 1,7 et 2,1 mm et par exemple de 1,9 mm.

Le matériau magnétique est un alliage de fer et de nickel de composition pondérable suivante:

Fer : 15%, Nickel : 75% à 82%, Molybdène : 3% à 7%,
Cuivre : 0% à 5%.

De préférence, le matériau magnétique possède la composition suivante :

Fer : 15%, Nickel : 80%, Molybdène : 5%.

Ce matériau magnétique doit posséder, après sa mise en forme et un éventuel traitement thermique, un champ coercitif inférieur ou égal à 10 mOe afin de garantir une précision suffisante du capteur de courant, celle-ci étant comprise entre 0,1 et 1% dans toute la gamme de mesure.

La fabrication d'un tel noyau magnétique 3 se résume à l'élaboration du fil, à sa découpe, sa mise en forme pour réaliser le tore, son traitement thermique et l'opération d'enroulement de l'enroulement de compensation 5. Il convient de noter que le fil est préalablement recouvert d'un vernis pour éviter le contact direct de l'enroulement de compensation 5 et du conducteur électrique primaire 4 avec le matériau magnétique.

L'enroulement de compensation 5 est constitué d'un fil de cuivre de diamètre compris entre 0,15 et 0,25 mm et par exemple égal à 0,2 mm enroulé autour du tore 3 de manière à former un nombre de spires par exemple égal à 2500.

La longueur du fil est telle que la résistance ohmique totale est inférieure à 20 ohms.

Cet enroulement 5 peut être enroulé directement sur le tore imprégné 3 sans que celui-ci nécessite un boîtier de protection.

Ainsi, le nombre d'opérations pour la fabrication du noyau magnétique 3 est considérablement réduit par rapport aux techniques de l'art antérieur puisqu'il se résume à deux étapes et permet donc une mise en oeuvre aisée.

Par ailleurs, la fabrication d'un tel capteur de courant continu occasionne une réduction de 50 à 75% du coût suivant le calibre envisagé par rapport à un capteur de courant de l'art antérieur.

Ce gain se répartit de façon sensiblement égale entre la matière première et les étapes de fabrication du capteur de courant.

En outre, le traitement thermique du noyau magnétique 3 est effectué après la mise en forme du tore, ce qui procure à celui-ci les caractéristiques optimales, par exemple un champ coercitif minimal, qui ne seront pas altérées par une mise en forme ultérieure comme dans l'art antérieur.

Dans le mode de réalisation décrit, l'intensité du courant à mesurer est comprise entre 200 et 400A et par exemple de l'ordre de 300A, la tension d'alimentation variant de 9 à 16V.

Selon l'art antérieur, un capteur de courant à effet Hall à flux nul comme celui précédemment décrit, comprend un noyau magnétique en forme de tore constitué d'un empilage par exemple de dix rondelles d'un matériau magnétique identique au précédent d'épaisseur égale à 0,3 mm ou 0,35 mm et de largeur égale à 6 mm.

Le tore a un diamètre moyen égal à 32 mm, le bobinage de flux nul possède un nombre de spires égal à 2000 réalisées dans un fil de diamètre égal à 0,15 mm.

Ainsi, le noyau magnétique 3 selon l'invention, et par exemple constitué d'un fil, possède une tenue mécanique comparable à celle que procure l'empilage de rondelles et permet de minimiser le volume de matériau magnétique employé pour réaliser le noyau 3, conduisant ainsi à un allégement du capteur de courant ce qui est toujours un atout dans le domaine des transports.

Par ailleurs, la longueur de la spire moyenne de l'enroulement de compensation 5 a considérablement diminué par rapport au capteur de courant de l'art antérieur ce qui permet de réduire la résistance de ce bobinage 5 d'environ 30% et de simplifier le bloc électronique amplificateur associé au capteur de courant.

L'invention permet de diminuer les capacités parasites dues au bobinage de flux nul 7 et donc d'augmenter les fréquences de travail.

L'invention permet également de réduire la tension d'alimentation du capteur ou sonde de courant 1 pour une intensité de courant à mesurer, un volume de capteur et une tension U à pleine échelle aux bornes de la résistance de mesure donnés. Ainsi, au lieu d'utiliser une alimentation -12 et +12V, il est également possible d'alimenter le capteur de courant en monotension, et par exemple avec une tension d'alimentation batterie de 9V.

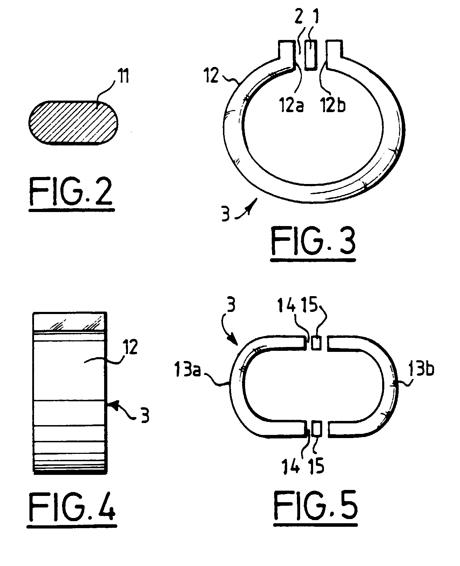

Selon un deuxième mode de réalisation, le noyau magnétique 3 peut être constitué par un méplat 11 tel que représenté sur la figure 2.

Ce méplat 11 a une épaisseur comprise entre 0,5 et 2 mm par exemple égale à 1 mm, et a une longueur comprise entre 1 et 5 mm et par exemple égale à 3 mm.

Selon un troisième mode de réalisation illustré par les figures 3 et 4, l'élément massif 3 en matériau magnétique est une bande 12 refermée sur elle même de manière à former un tore et dont les extrémités 12a et 12b se faisant face ménagent entre elles un entrefer 4.

La bande 12 a une épaisseur comprise entre 0,1 et 0,5 mm et une largeur comprise entre 2 et 5 mm, par exemple, la bande 12 a une épaisseur de 0,5 mm et une largeur de 3 mm.

Ces extrémités 12a,12b sont relevées à peu près à angle droit par rapport au reste de la bande 12 et tournées vers l'extérieur du tore (figure 3), offrant ainsi une plus grande surface de bande en regard de la partie active de la sonde à effet Hall 5 logée dans l'entrefer 4.

Les extrémités 12a et 12b relevées ont une hauteur égale et sont parallèles entre elles.

La largeur de ces extrémités 12a et 12b relevées est comprise entre 0,5 et 5 mm est par exemple égale à 3 mm.

La hauteur de ces extrémités 12a et 12b relevées est comprise entre 0,5 et 5 mm est par exemple égale à 3 mm.

Tel que représenté à la figure 5 selon un quatrième mode de réalisation, le noyau magnétique 3 est composé de deux parties 13a, 13b, chacune ayant une forme de U dont les branches se font face et ménagent entre elles deux entrefers 14 destinés au logement de deux sondes à effet Hall 15.

Chaque partie 13a,13b identique est formée par un fil, par exemple de section circulaire de diamètre égal à 3 mm.

Le capteur de courant selon l'invention s'applique tout particulièrement aux véhicules à propulsion électrique et permet de mesurer l'intensité de courants continus, alternatifs, continus et alternatifs superposés, impulsionnels jusqu'à des fréquences de quelques dizaines de kHz, voire de quelques centaines de kHz.

Les modes de réalisation précédents ne sont en aucune manière limitatifs et l'on conçoit aisément que le noyau magnétique peut prendre des formes diverses autres que le tore ou le double U, l'élément massif constituant ledit noyau magnétique pouvant lui aussi revêtir des formes variées même non décrites.

En outre, cette technologie peut parfaitement s'appliquer à tout autre domaine en conservant les avantages liés au faible coût de fabrication, à la faible consommation de courant électrique et à l'excellente précision dans la mesure de l'intensité du ou des courants électriques.

## Revendications

1. Dispositif de mesure de courant électrique comprenant au moins une sonde (1) sensible au flux magnétique disposée dans l'entrefer (2) d'un noyau annulaire (3) destiné à être traversé par au moins un conducteur (4) de courant à mesurer, un enroulement de compensation (5) bobiné sur le noyau (3), une résistance de mesure (6) connectée en série avec l'enroulement de compensation, caractérisé en ce que le noyau magnétique (3) est un élément en matériau massif, en ce qu'il comporte en outre un circuit (U1A,Q1,Q2,U1B,Q3,Q4) de régulation du courant d'alimentation de l'enroulement de compensation, quel que soit le sens du courant à mesurer, piloté par le signal de sortie du capteur sensible au flux magnétique, le circuit de régulation comporte un premier amplificateur (U1A) aux bornes d'entrée duquel est connectée la sonde (1) et dont la sortie est connectée aux bases d'une première paire de transistors (Q1,Q2) de types PNP et NPN dont les trajets émetteur-collecteur sont connectés entre la tension d'alimentation Vcc et la masse, la jonction des collecteurs de ces transistors étant connectée en série avec la résistance de mesure (6) à une première borne de l'enroulement de compensation (5) et un second amplificateur inverseur (U1B) connecté par sa borne inverseuse à la sortie du premier amplificateur (U1A) et dont la sortie est connectée aux bases d'une seconde paire de transistors (Q3,Q4) de types PNP et NPN, dont les trajets émetteur-collecteur sont connectés en série entre la tension d'alimentation Vcc et la masse, la jonction des collecteurs de ces transistors étant connectée à la seconde borne de l'enroulement de compensation (5) et en ce que le nombre de spires de l'enroulement de compensation est rendu compatible avec le courant à mesurer, la tension maximale d'alimentation disponible et la plage de mesure de la résistance de mesure du dispositif.

2. Dispositif de mesure selon la revendication 1, caractérisé en ce que le noyau magnétique (3) a une forme de tore.

3. Dispositif de mesure selon la revendication 2, caractérisé en ce que le tore a un diamètre moyen compris entre 10 et 200 mm et de préférence compris entre 30 et 50 mm pour un calibre de 200 à 1000A.

4. Dispositif de mesure selon la revendication 1, caractérisé en ce que l'entrefer (2) du noyau magnétique (3) a une largeur comprise entre 1,7 et 2,1 mm.

5. Dispositif de mesure selon l'une quelconque des revendications 1 à 4, caractérisé en ce que l'élément massif est constitué par un fil.

6. Dispositif de mesure selon la revendication 5, caractérisé en ce que le fil a une section circulaire.

7. Dispositif de mesure selon la revendication 6, caractérisé en ce que le fil a un diamètre compris entre 1,5 et 10 mm et de préférence compris entre 2 et 4 mm.

8. Dispositif de mesure selon l'une des revendications 1 à 4, caractérisé en ce que l'élément massif est un méplat (11).

9. Dispositif de mesure selon la revendication 8, caractérisé en ce que le méplat (11) a une épaisseur comprise entre 0,5 et 2 mm et une largeur comprise entre 1 et 5 mm.

10. Dispositif de mesure selon l'une des revendications 1 à 4, caractérisé en ce que l'élément massif est constitué par une bande (12) dont les extrémités (12a, 12b) ménagent entre elles l'entrefer (4) et sont relevées vers l'extérieur dudit élément massif de manière à faire face à la sonde à effet Hall (5).

11. Dispositif de mesure selon la revendication 10, caractérisé en ce que la bande (12) a une épaisseur comprise entre 0,1 et 0,5 mm et une largeur comprise entre 2 et 5 mm.

12. Dispositif de mesure selon l'une des revendications 10 et 11, caractérisé en ce que les extrémités relevées (12a,12b) de la bande (12) offrent une surface en regard de la sonde de mesure (1) dont la largeur est comprise entre 2 et 5 mm et dont la hauteur est comprise entre 0,5 et 5 mm.

13. Dispositif de mesure selon l'une des revendications 1 à 12, caractérisé en ce que le matériau magnétique est un alliage de fer et de nickel.

14. Dispositif de mesure selon la revendication 13, caractérisé en ce que l'alliage possède la composition pondérale suivante :
    Fer : 15%, Nickel : 75% à 82%,
    Molybdène : 3% à 7%, Cuivre : 0% à 5%.

15. Dispositif de mesure suivant la revendication 1, caractérisé en ce que le noyau magnétique (3) est composé de deux parties (13a,13b), chacune ayant une forme de U dont les branches se font face et ménagent entre elles deux entrefers (14) recevant chacun une sonde de mesure (15).

16. Dispositif de mesure selon l'une des revendications précédentes, caractérisé en ce que le matériau magnétique possède, après sa mise en forme et un éventuel traitement thermique, un champ coercitif inférieur ou égal à 10 mOe.

**Patentansprüche**

1. Vorrichtung für die Messung von elektrischem Strom mit mindestens einem auf den Magnetfluß ansprechenden Meßfühler (1), der in dem Luftspalt (2) eines ringförmigen Kerns (3) angeordnet ist, der von mindestens einem Leiter (4) für den zu messenden Strom durchguert wird, und mit einer auf den Kern (3) gewickelten Kompensationswicklung (5), und mit einem mit der Kompensationswicklung in Serie geschalteten Meßwiderstand (6),
   **dadurch gekennzeichnet, daß**
   der Magnetkern (3) ein Element aus einem massiven Werkstoff ist, und dadurch, daß sie außerdem einen Reglerkreis (U1A, Q1, Q2, U1B, Q3, Q4) für den Speisestrom der Kompensationswicklung unabhängig von der Richtung des zu messenden Stroms aufweist, welcher von dem Ausgangssignal des auf den Magnetfluß ansprechenden Stromwandlers gesteuert wird, und daß der Reglerkreis einen ersten Verstärker (U1A) aufweist, an dessen Eingangsklemmen der Meßfühler (1) angeschlossen ist, und dessen Ausgang an die Basis eines ersten Paars von Transistoren (Q1, Q2) vom Typ PNP und NPN angeschlossen ist, deren Auslenkungen Sender-Kollektor zwischen der Speisespannung Vcc und der Masse angeschlossen sind, wobei der Anschluß der Kollektoren dieser Transistoren mit dem Meßwiderstand (6) mit einer ersten Anschlußklemme der Kompensationswicklung (5) in Serie geschaltet ist, und ein zweiter Umschaltverstärker (U1B) mit seinem Umschaltkontakt an den Ausgang des ersten Verstärkers (U1A) angeschlossen ist, und dessen Ausgang an die Basis eines zweiten Transistorpaars (Q3, Q4) vom Typ PNP und NPN angeschlossen ist, deren Auslenkungen Sender-Kollektor zwischen der Speisespannung Vcc und der Masse in Serie geschaltet sind, und daß die Verbindung der Kollektoren der Transistoren an die zweite Anschlußklemme der Kompensationswicklung (5) angeschlossen sind, und dadurch, daß die Anzahl der Windungen der Kompensationswicklung mit dem zu messenden Strom, der maximal verfügbaren Speisespannung und dem Meßbereich des Meßwiderstandes der Vorrichtung abgestimmt wird.

2. Meßvorrichtung nach Anspruch 1,
   **dadurch gekennzeichnet, daß**
   der Magnetkern (3) die Form eines Torus hat.

3. Meßvorrichtung nach Anspruch 2,
   **dadurch gekennzeichnet, daß**
   der Torus einen mittleren Durchmesser zwischen 10 und 200 mm, vorzugsweise zwischen 30 und 50 mm bei einem Meßbereichsendwert von 200 bis 1.000 A hat.

4. Meßvorrichtung nach Anspruch 1,
   **dadurch gekennzeichnet, daß**
   der Luftspalt (2) des Magnetkerns (3) eine Breite zwischen 1,7 und 2,1 mm hat.

5. Meßvorrichtung nach einem der Ansprüche 1 bis 4,
   **dadurch gekennzeichnet, daß**
   das massive Element aus einem Draht besteht.

6. Meßvorrichtung nach Anspruch 5,
   **dadurch gekennzeichnet, daß**
   der Draht einen kreisförmigen Querschnitt hat.

7. Meßvorrichtung nach Anspruch 6,
   **dadurch gekennzeichnet, daß**
   der Draht einen Durchmesser zwischen 1,5 und 10 mm, und vorzugsweise zwischen 2 und 4 mm hat.

8. Meßvorrichtung nach einem der Ansprüche 1 bis 4,
   **dadurch gekennzeichnet, daß**
   das massive Element aus einer Flanke (11) besteht.

9. Meßvorrichtung nach Anspruch 8,
   **dadurch gekennzeichnet, daß**
   diese Flanke (11) eine Wandstärke zwischen 0,5 und 2 mm und eine Breite zwischen 1 und 5 mm besitzt.

10. Meßvorrichtung nach einem der Ansprüche 1 bis 4,
    **dadurch gekennzeichnet, daß**
    das massive Element aus einem Band (12) besteht, dessen Enden (12a, 12b) untereinander den Luftspalt (4) bilden und gegen die Außenseite des massiven Elementes so hochgezogen sind, daß sie dem Meßfühler mit Halleffekt (5) gegenüberliegen.

11. Meßvorrichtung nach Anspruch 10,
    **dadurch gekennzeichnet, daß**
    das Band (12) eine Wandstärke zischen 0,1 und 0,5 mm und eine Breite zwischen 2 und 5 mm besitzt.

12. Meßvorrichtung nach einem der Ansprüche 10 oder 11,
    **dadurch gekennzeichnet, daß**
    die hochgezogenen Enden (12a, 12b) des Bandes (12) eine Fläche gegenüber dem Meßfühler (1) bilden, deren Breite zwischen 2 und 5 mm und deren Höhe zwischen 0,5 und 5 mm liegt.

13. Meßvorrichtung nach einem der Ansprüche 1 bis 12,
    **dadurch gekennzeichnet, daß,**
    der magnetische Werkstoff aus einer Legierung aus Eisen und Nickel besteht.

14. Meßvorrichtung nach Anspruch 13,
    **dadurch gekennzeichnet daß,**
    die Legierung das folgende Gewichtsverhältnis hat:
    Eisen: 15 %, Nickel: 75 % bis 82 %,
    Molybden: 3 % bis 7 %, Kupfer: 0 % bis 5 %.

15. Meßvorrichtung nach Anspruch 1,
    **dadurch gekennzeichnet, daß**
    der Magnetkern (3) aus zwei Teilen (13a, 13b) besteht, die jeweils U-förmig ausgebildet sind und deren Schenkel einander gegenüberliegen und untereinander zwei Luftspalte (14) bilden, in die jeweils ein Meßfühler (15) eingesetzt ist.

16. Meßvorrichtung nach einem der vorausgegangenen Ansprüche,
    **dadurch gekennzeichnet, daß**
    der Magnetwerkstoff nach seiner Umformung und einer eventuellen Wärmebehandlung ein koerzitives Feld von weniger oder gleich 10 mOe besitzt.

**Claims**

1. Device for measuring an electric current incorporating at least one probe (1) sensitive to the magnetic flux located in the air gap (2) of an annular core (3) to be traversed by at least one conductor (4) of the current to be measured, a compensating winding (5) wound onto the core (3), a measuring resistor (6) connected in series with the compensating winding, characterized in that the magnetic core (3) is a solid material element, in that it also has a circuit (U1A, Q1, Q2, U1B, Q3, Q4) for controlling the supply current of the compensating winding, no matter what the direction of the current to be measured, controlled by the output signal of the magnetic flux-sensitive sensor, the control circuit having a first amplifier (U1A) to the input terminals of which is connected the probe (1) and whose output is connected to the bases of a first pair of transistors (Q1, Q2) of the PNP and NPN types, whose emitter-collector paths are connected between the supply voltage Vcc and earth, the junction of the collectors of these transistors being connected in series with the measuring resistor (6) to a first terminal of the compensating winding (5) and a second inverting amplifier (U1B) connected by its inverting terminal to the output of the first amplifier (U1A) and whose output is connected to the bases of a second pair of transistors (Q3, Q4) of the PNP and NPN types, whose emitter-collector paths are connected in series between the supply voltage Vcc and earth, the junction of the collectors of these transistors being connected to the second terminal of the compensating winding (5) and in that the number of turns of the compensating winding is made compatible with the current to be measured, the maximum supply voltage available and the measurement range of the measurement resistance of the device.

2. Measuring device according to claim 1, characterized in that the magnetic core (3) has the shape of a torus.

3. Measuring device according to claim 2, characterized in that the torus has a mean diameter between 10 and 200 mm and preferably between 30 and 50 mm for a range of 200 to 1000 A.

4. Measuring device according to claim 1, characterized in that the air gap (2) of the magnetic core (3) has a width between 1.7 and 2.1 mm.

5. Measuring device according to any one of the claims 1 to 4, characterized in that the solid element is constituted by a wire.

6. Measuring device according to claim 5, characterized in that the wire has a circular section.

7. Measuring device according to claim 6, characterized in that the wire has a diameter between 1.5 and 10 mm, preferably between 2 and 4 mm.

8. Measuring device according to one of the claims 1 to 4, characterized in that the solid element is a flat (11).

9. Measuring device according to claim 8, characterized in that the flat has a thickness between 0.5 and 2 mm and a width between 1 and 5 mm.

10. Measuring device according to one of the claims 1 to 4, characterized in that the solid element is constituted by a band (12), whose ends (12a, 12b) leave between them the air gap (4) and are raised towards the outside of said solid element so as to face the Hall effect probe (5).

11. Measuring device according to claim 10, characterized in that the band (12) has a thickness between 0.1 and 0.5 mm and a width between 2 and 5 mm.

12. Measuring device according to either of the claims 10 and 11, characterized in that the raised ends (12a, 12b) of the band (12) offer a surface facing the measuring probe (1), whose width is between 2 and 5 mm and whose height is between 0.5 and 5 mm.

13. Measuring device according to one of the claims 1 to 12, characterized in that the magnetic material is an alloy of iron and nickel.

14. Measuring device according to claim 13, characterized in that the alloy has the following weight composition: iron: 15%, nickel: 75 to 82%, molybdenum: 3 to 7% and copper: 0 to 5%.

15. Measuring device according to claim 1, characterized in that the magnetic core (3) is formed from two parts (13a, 13b), each of which has a U-shape, whose branches face one another and leave between them two air gaps (14), each receiving a measuring probe (15).

16. Measuring device according to one of the preceding claims, characterized in that the magnetic material, following its shaping and a possible heat treatment, has a coercive field equal to or below 10 MOe.

FIG.1

EP 0 692 098 B1

FIG.2

FIG.3

FIG.4

FIG.5